# EUROPEAN PATENT SPECIFICATION

(11) **EP 1 914 331 B1**
(45) Date of publication and mention of the grant of the patent: **24.07.2019**
(21) Application number: 07117451.0
(22) Date of filing: 28.09.2007
(51) Int. Cl.: C23C 14/08, C23C 16/40, C23C 28/04, C23C 28/00, C23C 30/00

(54) **Coated cutting tool**
Beschichtetes Schneidwerkzeug
Outil de coupe revêtu

(30) Priority: 18.10.2006 SE 0602192
(43) Date of publication of application: 23.04.2008
(73) Proprietor: Sandvik Intellectual Property AB, 811 81 Sandviken (SE)
(72) Inventor: Reineck, Ingrid, SE 141 72 Segeltorp (SE); Collin, Marianne, SE 125 54 Älvsjö (SE); Selinder, Torbjörn, SE 117 61 Stockholm (SE)
(74) Representative: Sandvik

(56) References cited:
- EP-A- 1 717 347
- WO-A-2004/029321
- WO-A1-99/58738
- US-A- 4 701 384
- KUNTZ J D ET AL: "NANOCRYSTALLINE MATRIX CERAMIC COMPOSITES FOR IMPROVED FRACTURE TOUGHNESS" MRS BULLETIN, PITTSBURGH, US, 1 January 2004 (2004-01-01), pages 22-27, XP008078761

## Description

The present invention relates to a coated cutting tool for metal machining having a substrate of a hard alloy and, on the surface of said substrate, a hard and wear resistant refractory coating deposited by Physical Vapour Deposition (PVD) or Plasma Enhanced Chemical Vapour Deposition (PECVD).

The process of depositing thin ceramic coatings (1-20 µm) of materials like alumina, titanium carbides and/or nitrides onto, e.g., a cemented carbide cutting tool is a well established technology and the tool life of the coated cutting tool, when used in metal machining, is considerably prolonged. The prolonged service life of the tool may under certain conditions extend up to several hundred percent greater than that of an uncoated cutting tool. These ceramic coatings generally comprise either a single layer or a combination of layers. Modern commercial cutting tools are characterized by a plurality of layer combinations with double or multilayer structures. The total coating thickness varies between 1 and 20 µm and the thickness of the individual sub-layers varies between a few micrometers down to some hundredths of a micrometer.

The established technologies for depositing such layers are CVD and PVD (see, e.g., U.S. 4,619,866 and U.S. 4,346,123). PVD coated commercial cutting tools of cemented carbides or high speed steels usually have a single layer of TiN, Ti(C,N) or (Ti,Al)N, homogeneous in composition, or multilayer coatings of said phases, each layer being a one phase material.

There exist several PVD techniques capable of producing thin, refractory coatings on cutting tools. The most established methods are ion plating, magnetron sputtering, arc discharge evaporation and IBAD (Ion Beam Assisted Deposition) as well as hybrid processes of the mentioned methods. Each method has its own merits and the intrinsic properties of the produced layers such as microstructure and grain size, hardness, state of stress, cohesion and adhesion to the underlying substrate may vary depending on the particular PVD method chosen. An improvement in the wear resistance or the edge integrity of a PVD coated cutting tool being used in a specific machining operation can thus be accomplished by optimizing one or several of the above mentioned properties.

Particle strengthened ceramics are well known as construction materials in the bulk form, however not as nano-composites until recently. Alumina bulk ceramics with different nano-dispersed particles are disclosed in J. F. Kuntz et al, MRS Bulletin Jan 2004, pp 22 - 27. Zirconia and titania toughened alumina CVD layers are disclosed in for example US 6,660,371 and US 4,701,384. In these latter disclosures, the layers are deposited by CVD technique and hence the ZrO₂ phase formed is the thermodynamically stable phase, namely the monoclinic phase. Furthermore, the CVD deposited layers are in general under tensile stress or low level compressive stress, whereas PVD or PECVD layers are typically under high level compressive stress due to the inherent nature of these deposition processes. In US 2005/0260432 blasting of alumina+zirconia CVD layers is described to give a compressive stress level. Blasting processes are known to introduce compressive stresses at moderate levels.

Metastable phases of zirconia, such as the tetragonal or cubic phases, have been shown to further enhance bulk ceramics through a mechanism known as transformation toughening (Hannink et al, J. Am. Ceram. Soc 83 (3) 461 - 87; Evans, Am. Ceram. Soc. 73 (2) 187-206 (1990)). Such metastable phases have been shown to be promoted by adding stabilizing elements such as Y or Ce or by the presence of an oxygen deficient environment, such as vacuum (Tomaszewski et al, J. Mater. Sci. Lett 7 (1988) 778-80), which is typically required for PVD applications. Variation of PVD process parameters has been shown to cause variations in the oxygen stoichiometry and the formation of metastable phases in zirconia, particularly the cubic zirconia phase (Ben Amor et al, Mater. Sci. Eng. B57 (1998) 28) .

Multilayered PVD layers consisting of metal nitrides or carbides for cutting applications are described in EP 0709483 where a symmetric multilayer structure of metal nitrides and carbides is revealed and US 6,103,357 which describes an aperiodic laminated multilayer of metal nitrides and carbides.

Swedish Patent Application No. SE 0500867-7 and SE 0600104-4 disclose a cutting tool insert for metal machining on which at least on the functioning parts of the surface thereof a thin, adherent, hard and wear resistant coating is applied. The coating comprises a metal oxide+metal oxide nano-composite layer consisting of two components with a grain size of 1 - 100 nm.

WO 99/58738 A1 discloses an article comprising a substrate of, e.g., cemented carbide and a multilayered CVD coating exhibiting improved coating properties.

It is an object of the present invention to provide a PVD or PECVD coated cutting tool with improved wear properties in combination with improved resistance to thermally initiated failure.

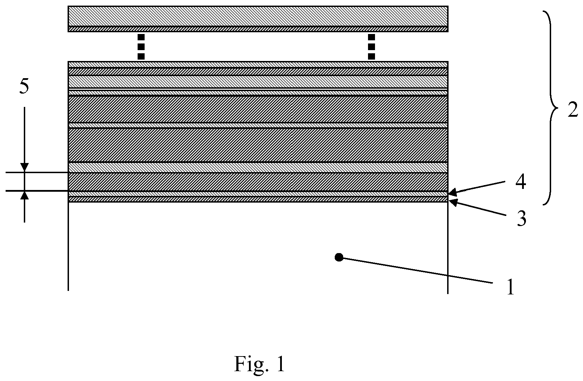

Fig 1 is a schematic representation of a cross section taken through a coated cutting tool of the present invention showing a substrate (1) coated with an aperiodic, laminated multilayer (2) with individual metal oxide+metal oxide nano-composite layers Me₁X (3), Me₂X (4) each having an individual layer thickness (5). The sequence of the individual layer thicknesses is essentially aperiodic throughout the entire multilayer.

According to the present invention, there is provided a cutting tool for metal machining such as turning, milling and drilling comprising a substrate of a hard alloy of cemented carbide, cermet, ceramics, cubic boron nitride or high speed steel, preferably cemented carbide or cermet, onto which a wear resistant coating comprising a laminated multilayer has been deposited. The shape of the cutting tool includes indexable inserts as well as shank type tools such as drills, end mills etc. The coating may in addition comprise, beneath the laminated multilayer, a first, inner single layer or multilayer of metal carbides, nitrides or carbonitrides where the metal atoms are one or more of Ti, Nb, V, Mo, Zr, Cr, Al, Hf, Ta, Y or Si with a thickness in the range 0.2 to 20 µm according to prior art.

The coating is applied onto the entire substrate or at least the functioning surfaces thereof, e.g., the cutting edge, rake face, flank face and any other surfaces which participate in the metal cutting process.

The coating according to the invention is adherently bonded to the substrate and comprises a laminated multilayer of alternating PVD or PECVD metal oxide layers, Me₁X+Me₂X+Me₁X+Me₂X..., where the metal atoms Me₁ and Me₂ are one or more of Ti, Nb, V, Mo, Zr, Cr, Al, Hf, Ta, Y and Si, preferably Hf, Ta, Cr, Zr and Al, most preferably Zr and Al, and where at least one of Me₁X and Me₂X is a nano-composite layer of a dispersed metal oxide component in a metal oxide matrix, hereinafter referred to as a metal oxide+metal oxide nano-composite. The layers Me₁X and Me₂X are different in composition or structure or both these properties. The sequence of the individual Me₁X or Me₂X layer thicknesses is preferably aperiodic throughout the entire multilayer. By aperiodic is understood that the thickness of a particular individual layer in the laminated multilayer does not depend on the thickness of an individual layer immediately beneath nor does it bear any relation to an individual layer above the particular individual layer. Hence, the laminated multilayer does not have any repeat period in the sequence of individual coating thicknesses. Furthermore, the individual layer thickness is larger than 0.4 nm but smaller than 50 nm, preferably larger than 1 nm and smaller than 30 nm, most preferably larger than 5 nm and smaller than 20 nm. The laminated multilayer has a total thickness of between 0.2 and 20 µm, preferably 0.5 and 5 µm. The laminated multilayer possesses a residual stress being compressive in the range 200 and 5000 MPa.

One individual metal oxide+metal oxide nano-composite layer is composed of two components with different composition and different structure. Each component is a single phase oxide of one metal element or a solid solution of two or more metal oxides. The microstructure of the material is characterized by nano-sized grains or columns of a component A with an average grain or column size of 1 - 100 nm, preferably 1 - 70 nm, most preferably 1 - 20 nm, surrounded by a component B. The mean linear intercept of component B is 0.5 - 200 nm, preferably 0.5 - 50 nm, most preferably 0.5 - 20 nm.

The metal oxide+metal oxide nano-composite layer is understoichiometric in oxygen content with an oxygen:metal atomic ratio which is 85 - 99 %, preferably 90 - 97 %, of stoichiometric oxygen:metal atomic ratio. The volume contents of components A and B are 40 - 95 % and 5 - 60 % respectively.

In one exemplary embodiment of the invention, Me₁X is a metal oxide+metal oxide nano-composite layer containing grains or columns of component A, preferably in the form of tetragonal or cubic zirconia, and a surrounding component B, preferably in the form of amorphous or crystalline alumina being one or both of alpha (α) and gamma (γ) phase, and Me₂X is a Al₂O₃ layer, preferably being one or both of alpha (α) and gamma (γ) phase.

In another exemplary embodiment of the invention, Me₁X is a metal oxide+metal oxide nano-composite layer containing grains or columns of component A in the form of an oxide of hafnium and a surrounding component B in the form of amorphous or crystalline alumina being one or both of alpha (α) and gamma (γ) phase, and Me₂X is a Al₂O₃ layer, preferably being one or both of alpha (α) and gamma (γ) phase.

In another exemplary embodiment of the invention, Me₁X is a metal oxide+metal oxide nano-composite layer containing grains or columns of component A and a surrounding component B, and Me₂X is a metal oxide+metal oxide nano-composite layer containing grains or columns of component A and a surrounding component B, wherein the metal atom(s) of component A of Me₁X is different from the metal atom(s) of component A of Me₂X and/or the metal atom(s) of component B of Me₁X is different from the metal atom(s) of component B of Me₂X.

In yet another exemplary embodiment of the invention, Me₁X is a metal oxide+metal oxide nano-composite layer containing grains or columns of component A in the form of tetragonal or cubic zirconia and a surrounding component B in the form of amorphous or crystalline alumina, and Me₂X is a metal oxide+metal oxide nano-composite layer containing grains or columns of component A in the form of tetragonal or cubic zirconia and a surrounding component B in the form of amorphous or crystalline alumina, wherein the volume content of components A in Me₁X is > the volume content of components A in Me₂X, preferably the volume content of components A in Me₁X is at least 2.5 % more than the volume content of components A in Me₂X in absolute units, most preferably the volume content of components A in Me₁X is at least 5 % more than the volume content of components A in Me₂X in absolute units.

The laminated multilayer also possesses a residual stress as a result of the method of production, the stress being compressive preferably in the range 1000 and 3000 MPa.

The coating may in addition comprise, on top of the laminated multilayer, an outer single layer or multilayer of metal carbides, nitrides or carbonitrides where the metal atoms are one or more of Ti, Nb, V, Mo, Zr, Cr, Al, Hf, Ta, Y and Si. The thickness of this layer is 0.2 - 5 µm.

The layer according to the present invention is made by a PVD technique, a PECVD technique or a hybrid of such techniques. Examples of such techniques are RF (Radio Frequency) magnetron sputtering, DC magnetron sputtering and pulsed dual magnetron sputtering (DMS). The layer is formed at a substrate temperature of 200 - 850°C.

When the type of PVD process permits, a metal oxide+metal oxide nano-composite layer is deposited using a composite oxide target material. A reactive process using metallic targets in an ambient reactive gas is an alternative process route. For the case of production of the metal oxide layers by a magnetron sputtering method, two or more single metal targets may be used where the metal oxide+metal oxide nano-composite composition is steered by switching on and off of separate targets. In a preferred method a target is a compound with a composition that reflects the desired layer composition. For the case of radio frequency (RF) sputtering, the composition is controlled by applying independently controlled power levels to the separate targets.

The aperiodic layer structure may be formed through the multiple rotation of substrates in a large scale PVD or PECVD process.

### Example 1

An aperiodic laminated multilayer consisting of alternating metal oxide+metal oxide nano-composite Al₂O₃ + ZrO₂ layers and Al₂O₃ layers, was deposited on a substrate using an RF sputtering PVD method.

The nano-composite layers were deposited with high purity oxide targets applying different process conditions in terms of temperature and zirconia to alumina ratio. The content of the two oxides in the formed nano-composite layer was controlled by applying one power level on the zirconia target and a separate power level on the alumina target. Alumina was added to the zirconia flux with the aim to form a composite material having metastable ZrO₂ phases. The target power level for this case was 80 W on each oxide target. The sputter rates were adjusted to obtain two times higher at-% of zirconium compared to aluminium. The oxygen:metal atomic ratio was 94 % of stoichiometric oxygen:metal atomic ratio.

The Al₂O₃ layers were deposited using alumina targets in an argon atmosphere.

The resulting layers were analyzed by XRD and TEM. The XRD analysis showed no traces of crystalline Al₂O₃ in the nano-composite layer, while the Al₂O₃ layers consisted mainly of gamma Al₂O₃.

The TEM investigation showed that the deposited coating consisted of a laminated multilayer of alternating metal oxide+metal oxide nano-composite layers, comprising grains with an average grain size of 4 nm (component A) surrounded by an amorphous phase with a linear intercept of 2 nm (component B), and gamma Al₂O₃ layers. The grains of the nano-composite layers were cubic ZrO₂ while the surrounding phase had high aluminium content. The individual layer thicknesses ranged from 6 to 20 nm and the total multilayer thickness was about 1 µm.

The relative volume content of the two components A and B was approximately 70 % and 30 %, respectively, as determined from ERDA analysis and EDS line scans from TEM images.

### Example 2

A laminated multilayer coating consisting of alternating metal oxide+metal oxide nano-composite layers of Al₂O₃ + ZrO₂ and gamma Al₂O₃ layers was deposited on a substrate using a reactive RF sputtering PVD method with high purity Al and Zr targets in an argon and oxygen atmosphere. The content of the two oxides in the formed layer was controlled by applying one power level on the Zr target and a separate power level on the Al target. The sputter rates were adjusted with the aim to form a composite material with 1-2 times higher at-% of zirconium. The Al₂O₃ layers were deposited using aluminium targets in an argon + oxygen atmosphere.

The XRD results showed presence of metastable ZrO₂ phases in the nano-composite layers. The TEM investigation showed that the deposited coating consisted of a laminated multilayer of alternating metal oxide+metal oxide nano-composite layers, comprising grains with an average grain size of 6 nm (component A) surrounded by an amorphous phase with a linear intercept of 3 nm (component B), and gamma Al₂O₃ layers. The grains of the nano-composite layers had high zirconium content while the surrounding phase had high aluminium content. The individual layer thicknesses ranged from 10 to 20 nm and the total multilayer thickness was about 3 µm.

The relative volume content of the two components A and B was approximately 75 % and 25 %, respectively, as determined from ERDA analysis and EDS line scans from TEM images.

### Example 3

A laminated multilayer coating consisting of two alternating metal oxide+metal oxide nano-composite layers of Al₂O₃ + ZrO₂ was deposited on a substrate using a dual magnetron sputtering PVD method with high purity Al+Zr targets in an argon and oxygen atmosphere. The content of the two oxides in the formed respective nano-composite layers was controlled by the relative content of the two elements in the targets. The substrates were subjected to a threefold rotation by rotation of the whole substrate table, the separate holders for the pins where the substrates are mounted and the individual pins.

The XRD results showed presence of metastable ZrO₂ phases in the layers. The TEM investigation showed that the deposited coating consisted of a laminated multilayer of two alternating metal oxide+metal oxide nano-composite layers, comprising grains with an average grain size of 6 nm (component A). The grains of the layers had high zirconium content while the surrounding phase had high aluminium content. The individual layer thicknesses ranged from 10 to 20 nm and the total multilayer thickness was about 3 µm.

ERDA analysis and EDS line scans from TEM images revealed that the laminated multilayer consisted of alternating layers: a first layer type having a volume content of component A of about 70 % and component B of about 30, and a second layer type having a volume content of component A of about 50 % and component B of about 50 %.

## Claims

1. A cutting tool comprising a substrate of cemented carbide, cermet, ceramics, cubic boron nitride or high speed steel on which at least on the functioning parts of the surface thereof a thin, adherent, hard and wear resistant coating is applied, **characterised in** said coating comprises a laminated multilayer of alternating PVD or PECVD metal oxide layers, Me₁X+Me₂X+Me₁X+Me₂X..., where the metal atoms Me₁ and Me₂ are one or more of Ti, Nb, V, Mo, Zr, Cr, Al, Hf, Ta, Y and Si, and at least one of Me₁X and Me₂X is a metal oxide+metal oxide nano-composite layer composed of two components, component A and component B, with different composition and different structure which components consist of a single phase oxide of one metal element or a solid solution of two or more metal oxides, wherein the layers Me₁X and Me₂X are different in composition or structure or both these properties and have individual layer thicknesses larger than 0.4 nm but smaller than 50 nm and where said laminated multilayer has a total thickness of between 0.2 and 20 pm, the laminated multilayer possesses a residual stress being compressive in the range 200 and 5000 MPa.

2. Cutting tool according to the preceding claim **characterised in that** the metal atoms Me₁ and Me₂ are one or more of Hf, Ta, Cr, Zr and Al.

3. Cutting tool according to the preceding claims **characterised in that** the metal atoms Me₁ and Me₂ are one or more of Zr and Al.

4. Cutting tool according to the preceding claims **characterised in that** the said individual Me₁X and Me₂X layer thicknesses are larger than 1 nm and smaller than 30 nm.

5. Cutting tool according to the preceding claims **characterised in that** the coating in addition comprises a first, inner single layer or multilayer of metal carbides, nitrides or carbonitrides with a thickness between 0.2 and 20 µm where the metal atoms are chosen from one or more of Ti, Nb, V, Mo, Zr, Cr, Al, Hf, Ta, Y or Si.

6. Cutting tool according to any of the preceding claims **characterised in that** the coating additionally comprises, on top of the laminated multilayer, an outer single layer or multilayer coating of metal carbides, nitrides or carbonitrides with a thickness between 0.2 and 5 µm where the metal atoms are chosen from one or more of Ti, Nb, V, Mo, Zr, Cr, Al, Hf, Ta, Y or Si.

7. Cutting tool according to any of the preceding claims **characterised in that** said component A has an average grain size of 1 - 100 nm, preferably 1 - 70 nm, most preferably 1 - 20 nm.

8. Cutting tool according to the preceding claims **characterised in that** said component B has a mean linear intercept of 0.5 - 200 nm, preferably 0.5 - 50 nm, most preferably 0.5 - 20 nm.

9. Cutting tool according to any of the preceding claims **characterised in that** the volume contents of component A and B are 40 - 95 % and 5 - 60 % respectively.

10. Cutting tool according to any of the preceding claims **characterised in that** said component A contains tetragonal or cubic zirconia and said component B is amorphous or crystalline alumina, being of one or both of the alpha (α) and the gamma (γ) phase.

11. Cutting tool according to any of the preceding claims **characterised in that** Me₁X is a metal oxide+metal oxide nano-composite layer and Me₂X is crystalline alumina layer of one or both of the alpha (α) and the gamma (γ) phase.

## Patentansprüche

1. Schneidewerkzeug, umfassend ein Substrat aus Hartmetall, Cermet, Keramiken, kubischem Boronnitrid oder Schnellstahl, auf das, zumindest auf die Funktionsteile der Oberfläche davon, eine dünne, haftende, harte und verschleißfeste Beschichtung aufgetragen wird,
**dadurch gekennzeichnet, dass** besagte Beschichtung eine laminierte Mehrfachschicht aus alternierenden PVD- oder PECVD-Metalloxidschichten, Me₁X+Me₂X+Me₁X+Me₂X..., umfasst, in denen die Metallatome Me₁ und Me₂ eines oder mehrere aus Ti, Nb, V, Mo, Zr, Cr, Al, Hf, Ta, Y und Si sind, und zumindest eines aus Me₁X und Me₂X ein Metalloxid + Metalloxid-Nanoverbundschicht, gebildet aus zwei Komponenten, Komponente A und Komponente B, mit unterschiedlicher Zusammensetzung und unterschiedlicher Struktur, welche Komponenten aus einem einphasigen Oxid eines Metallelements oder einem Mischkristall aus zwei oder mehr Metalloxiden bestehen, wobei die Schichten Me₁X und Me2X sich in Zusammensetzung oder Struktur oder in diesen beiden Eigenschaften unterscheiden und individuelle Schichtdicken größer als 0,4 nm, jedoch kleiner als 50 nm aufweisen und in denen die besagte laminierte Mehrfachschicht eine Gesamtdicke von zwischen 0,2 und 20 µm aufweist und die laminierte Mehrfachschicht eine Druckeigenspannung besitzt, die im Bereich zwischen 200 und 5.000 MPa ist.

2. Schneidewerkzeug gemäß dem vorhergehenden Anspruch, **dadurch gekennzeichnet, dass** die Metallatome Me₁ und Me₂ eines oder mehrere aus Hf, Ta, Cr, Zr und Al sind.

3. Schneidewerkzeug gemäß den vorhergehenden Ansprüchen, **dadurch gekennzeichnet, dass** die Metallatome Me₁ und Me₂ eines oder mehrere aus Zr und Al sind.

4. Schneidewerkzeug gemäß den vorhergehenden Ansprüchen, **dadurch gekennzeichnet, dass** die besagte individuellen Me₁X- und Me₂X-Schichtdicken größer als 1 nm und kleiner als 30 nm sind.

5. Schneidewerkzeug gemäß den vorhergehenden Ansprüchen, **dadurch gekennzeichnet, dass** die Beschichtung zusätzlich eine erste, innere Einzelschicht oder Mehrfachschicht aus Metallkarbiden, Nitriden oder Karbonitriden mit einer Dicke zwischen 0,2 und 20 µm umfasst, in der die Metallatome aus einem oder mehreren aus Ti, Nb, V, Mo, Zr, Cr, Al, Hf, Ta, Y oder Si ausgewählt werden.

6. Schneidewerkzeug gemäß beliebigen der vorhergehenden Ansprüche, **dadurch gekennzeichnet, dass** die Beschichtung zusätzlich auf der laminierten Mehrfachschicht eine erste, äußere Einzelschicht oder Mehrfachbeschichtung aus Metallkarbiden, Nitriden oder Karbonitriden mit einer Dicke zwischen 0,2 und 5 µm umfasst, in der die Metallatome ausgewählt werden aus einem oder mehreren aus Ti, Nb, V, Mo, Zr, Cr, Al, Hf, Ta, Y oder Si.

7. Schneidewerkzeug gemäß einem beliebigen der vorhergehenden Ansprüche, **dadurch gekennzeichnet, dass** besagte Komponente A eine durchschnittliche Korngröße von 1 bis 100 nm, bevorzugt 1 bis 70 nm, und am meisten bevorzugt zwischen 1 und 20 nm aufweist.

8. Schneidewerkzeug gemäß den vorhergehenden Ansprüchen, **dadurch gekennzeichnet, dass** besagte Komponente B einen durchschnittlichen Linienschnitt von 0,5 bis 200 nm, bevorzugt 0,5 bis 50 nm, und am meisten bevorzugt von 0,5 bis 20 nm aufweist.

9. Schneidewerkzeug gemäß einem beliebigen der vorhergehenden Ansprüche, **dadurch gekennzeichnet, dass** die Volumengehalte von Komponente A und B 40 bis 95 % bzw. 5 bis 60 % betragen.

10. Schneidewerkzeug gemäß einem der vorhergehenden Ansprüche, **dadurch gekennzeichnet dass** besagte Komponente A tetragonales oder kubisches Zirkonoxid enthält und besagte Komponente B amorphes oder kristallines Aluminiumoxid einer oder beider der Alpha- (α) und der Gamma- (γ) Phase ist.

11. Schneidewerkzeug gemäß einem beliebigen der vorhergehenden Ansprüche, **dadurch gekennzeichnet, dass** Me₁X ein Metalloxid + Metalloxid-Nanoverbundschicht und Me₂X kristalline Aluminiumoxidschicht einer oder beider der Alpha- (α) und der Gamma- (γ) Phase ist.

## Revendications

1. Outil de coupe comprenant un substrat de carbure cémenté, de cermet, de céramique, de nitrure de bore cubique ou d'acier rapide sur lequel, au moins sur les éléments fonctionnels de sa surface, un revêtement fin, adhérent, dur et résistant à l'usure est appliqué,
**caractérisé en ce que** ledit revêtement comprend une multicouche stratifiée de couches d'oxyde métallique PVD ou PECVD alternées, Me₁X+Me₂X+Me₁X+Me₂X..., où les atomes de métal Me₁ et Me₂ sont un ou plusieurs parmi Ti, Nb, V, Mo, Zr, Cr, Cr, Al, Hf, Ta, Y et Si, et au moins l'un de Me₁X et Me₂X est une couche nanocomposite oxyde métallique + oxyde métallique composée de deux composants, composant A et composant B, avec une composition différente et une structure différente, lesdits composants consistent en un oxyde monophasé d'un élément métallique ou une solution solide de deux ou plusieurs oxydes métalliques, où les couches Me₁X et Me2X sont différentes en composition ou en structure ou dans les deux propriétés et ont une épaisseur de couche individuelle supérieure à 0,4 nm, mais inférieure à 50 nm, et où ladite multicouche stratifiée a une épaisseur totale entre 0,2 et 20 µm, la multicouche stratifiée possède une contrainte résiduelle de compression dans la plage comprise entre 200 et 5000 Mpa.

2. Outil de coupe selon la revendication précédente, **caractérisé en ce que** les atomes de métal Me₁ et Me₂ sont un ou plusieurs parmi Hf, Ta, Cr, Zr et Al.

3. Outil de coupe selon les revendications précédentes, **caractérisé en ce que** le métal atomise Me₁ et Me₂ sont un ou plusieurs Zr et Al.

4. Outil de coupe selon les revendications précédentes, **caractérisé en ce que** lesdites épaisseurs de couche individuelle de Me₁X et de Me₂X sont supérieures à 1 nm et inférieures à 30 nm.

5. Outil de coupe selon les revendications précédentes, **caractérisé en ce que** le revêtement comprend en outre une première couche interne unique ou une multicouche de carbures métalliques, de nitrures ou de carbonitrures avec une épaisseur entre 0,2 et 20 µm où les atomes métalliques sont choisis parmi un ou plusieurs des éléments Ti, Nb, V, Mo, Zr, Cr, Al, Hf, Ta, Y ou Si.

6. Outil de coupe selon l'une quelconque des revendications précédentes, **caractérisé en ce que** le revêtement comprend en outre, sur le dessus de la multicouche stratifiée, une couche externe unique ou une multicouche de carbures métalliques, de nitrures ou de carbonitrures avec une épaisseur entre 0,2 et 5 µm où les atomes métalliques sont choisis parmi un ou plusieurs des éléments Ti, Nb, V, Zr, Cr, Al, Hf, Ta, Y ou Si.

7. Outil de coupe selon l'une quelconque des revendications précédentes, **caractérisé en ce que** ledit composant A a une taille de grain moyenne entre 1 et 100 nm, de préférence entre 1 et 70 nm, idéalement entre 1 et 20 nm.

8. Outil de coupe selon les revendications précédentes, **caractérisé en ce que** ledit composant B a une interception linéaire moyenne entre 0,5 et 200 nm, de préférence entre 0,5 et 50 nm, idéalement entre 0,5 et 20 nm.

9. Outil de coupe selon l'une quelconque des revendications précédentes, **caractérisé en ce que** les teneurs du volume des composants A et B sont de 40 et 95 % et de 5 à 60 % respectivement.

10. Outil de coupe selon l'une quelconque des revendications précédentes, **caractérisé en ce que** ledit composant A contient de la zircone tétragonale ou cubique et que ledit composant B est amorphe ou l'alumine cristalline, étant dans l'une de la phase alpha (α) et de la phase gamma (γ) ou dans les deux.

11. Outil de coupe selon l'une quelconque des revendications précédentes, **caractérisé en ce que** Me₁X est une couche nanocomposite oxyde métallique+oxyde métallique et ME₂X est une couche d'alumine cristalline dans l'une de la phase alpha (α) et de la phase gamma (γ) ou dans les deux.
